(19) Europäisches Patentamt
European Patent Office
Office européen des brevets

(11) Publication number: **0 166 549**
**A2**

# (12) EUROPEAN PATENT APPLICATION

(21) Application number: **85303998.0**

(22) Date of filing: **05.06.85**

(51) Int. Cl.⁴: **H 01 J 37/317**, G 03 F 7/20

(30) Priority: **21.06.84 US 623262**

(43) Date of publication of application: **02.01.86**
**Bulletin 86/1**

(84) Designated Contracting States: **CH DE FR GB LI NL**

(71) Applicant: **VARIAN ASSOCIATES, INC., 611 Hansen Way, Palo Alto, CA 94303 (US)**

(72) Inventor: **Pavkovich, John M., 2945 Alexis Drive, Palo Alto California 94303 (US)**

(74) Representative: **Cline, Roger Ledlie, STANLEY, POPPLEWELL, POOLE 57 Lincoln's Inn Fields, London WC2A 3LS (GB)**

(54) **Method for proximity effect correction in electron beam lithography systems.**

(57) A method for electron beam lithography writing of a microminiature pattern P(x, y) in a resist-coated workpiece, the method comprising the steps of calculating, at a plurality of grid points on the workpiece, the electron dosage required to produce uniform exposure of the pattern P in accordance with the expression

$$\frac{1}{A + B \cdot P_* S} + \frac{B^2 \beta_b^2}{2} [\nabla \cdot (P_* S)]^2$$

where S represents the backscattered exposure distribution produced by an incident electron beam, and A, B and $\beta_b$ are constants. The pattern is then written on the workpiece with the electron beam while varying the applied electron dosage in accordance with the calculated values of required electron dosage. In a preferred embodiment, the electron dosage applied by the electron beam lithography system is varied between a number of discrete levels. The features of the pattern P are partitioned into subfeatures in accordance with the calculated values of required electron dosage. The subfeatures are then assigned to one of the discrete dosage levels of the system.

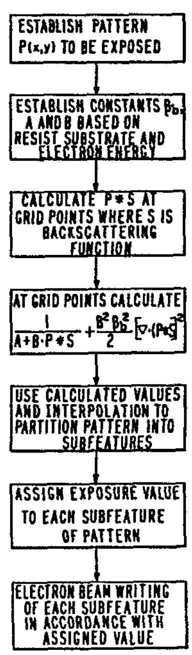

# Method For Proximity Effect Correction In Electron Beam Lithography Systems

## Background of the Invention

This invention relates to electron beam lithography systems for selectively irradiating workpieces and, more particularly, to a technique for producing uniformly exposed patterns in a resist-coated workpiece by correcting for the proximity effect.

Electron beam exposure systems are used commercially for selectively irradiating a resist-coated workpiece to define the features of a semiconductor device. The workpiece can be a mask plate or can be a resist-coated semiconductor wafer in which features are defined directly. In either case, an electron beam is controlled in a highly accurate, high speed manner to expose complex microminiature patterns in the electron resist material. The minimum feature dimensions can be less than one micrometer. As semiconductor devices with greater complexity are designed, the desire is to reduce pattern dimensions even further.

In order to expose these microminiature patterns, the electron beam is focused and shaped to the required dimension and applied to the electron sensitive resist. In addition, the beam is deflected to the prescribed pattern locations on the workpiece. A variety of shaping and deflection techniques have been utilized. As the electron beam passes through the finite thickness of the resist layer, it chemically changes, or exposes, the resist material. Ideally, the electron beam exposes the resist only in the areas to which the beam is applied. However, in reality, as the beam passes through the resist material, the electrons are forward scattered by resist molecules. In addition, when the electrons strike the resist-substrate interface and pass into the bulk of the substrate, they are backscattered into the resist. The net result is a spreading of the exposed region. Typically, the backscattered electrons affect a considerably larger area of the resist than forward scattered electrons. This spreading effect is commonly known as the proximity effect and has proved to be a serious problem in electron beam lithography, particularly as device features have become smaller. Relatively large pattern areas are increased in size when the interior of the pattern feature is correctly exposed. The gap between closely spaced features is decreased or eliminated entirely due to the proximity effect. Normally uniform features can be rendered nonuniform in regions where they are close to other features.

Techniques have been proposed to reduce the proximity effect. These include varying the energy of the electrons in the beam and varying the materials of the substrate and the resist. Multi-layer resists have also been utilized. An electron-absorbing layer is deposited between the resist layer and the substrate to absorb backscattered electrons and to reduce exposure of the resist by backscattered electrons. None of these techniques have proved satisfactory. Since the proximity effect has not been reduced to acceptable levels, efforts have been made to correct or compensate for the effect and produce acceptable patterns. Corrections have fallen into two main categories: 1) adjustment of pattern dimensions; and 2) adjustment of electron exposure. In pattern dimension compensation, the features of the device are reduced in dimension by an amount equivalent to the spreading effect with the resultant pattern having the prescribed dimensions. While simple in concept, the pattern dimension adjustment technique has proven extremely difficult in dealing with complex patterns. In the exposure adjustment technique, the number of electrons, or dosage, applied to the resist per unit area is varied by controlling the dwell time, scan speed, or current of the beam.

A technique known as the self-consistent method has been utilized for exposure adjustment correction (see M. Parikh, "Proximity Effects in Electron Lithography: Magnitude and Correction Techniques," IBM J. Res. Develop., Vol. 24, No. 4, July 1980, p. 438). An average value of exposure is computed for each feature in the pattern by summing the exposure at each incremental pattern area due to spreading from surrounding pattern areas. The average exposure levels are defined as equal, and a set of equations is solved for the incident electron density to be applied to each feature. The self-consistent technique is in general acceptable for proximity correction but has disadvantages. The pattern features must be appropriately subdivided, or partitioned, before performing the above calculation, since all portions of a feature are not subject to the same proximity effect, depending on their size and nearness to other features. The partitioning must be done in advance of the exposure level calculation and in accordance with a separate algorithm. Thus, the self-consistent method involves two separate complex steps. Furthermore, the result of the exposure level calculation does not provide information as to the adequacy of the partitioning process. It is desirable to provide a proximity effect correction technique which not only supplies the required exposure level of each pattern feature or subfeature to achieve uniformity but also provides information regarding partitioning of the pattern features.

In another compensation technique, the desired pattern is exposed with a normal electron dosage. Then, the negative of the pattern is exposed by a reduced electron dosage approximating that due to backscattering. The result is a uniform low level of exposure in non-pattern areas (see European Patent Publication No. 0097417, published January 4, 1984).

According to the invention there is provided a method of electron beam lithography as set out in any one of claims 1, 11 and 14.

In accordance with one embodiment there is provided a method for electron beam lithography writing of a microminiature pattern P(x, y) in a resist-coated workpiece. The method comprises the steps of calculating, at a plurality of locations on the workpiece, the electron dosage required to produce uniform exposure of the pattern P(x, y) in accordance with the expression

$$\frac{1}{A + B.P(x, y)*S(x, y)}$$

where S(x, y) represents the backscattered exposure distribution produced by an incident electron beam, P(x, y)*S(x, y) represents the convolution of P and S, and A and B are constants dependent on the parameters of said resist and said workpiece and on the energy of the incident electrons. The pattern P(x, y) is then written on the workpiece with the electron beam from the electron beam system while varying the applied electron dosage in accordance with the calculated values of required electron dosage.

In a preferred embodiment, a correction factor

$$\frac{B^2\beta_b{}^2}{2}\left[\nabla\cdot(P*S)\right]^2$$

where $\beta_b$ is the characteristic width of the exposure distribution, is added to the values of required electron dosage.

In another preferred embodiment, the electron dosage applied by the electron beam lithography system is varied between a number of discrete levels. The features of the pattern P(x, y) are partitioned into subfeatures in accordance with the calculated values of required electron dosage. The subfeatures are then assigned to one of the discrete dosage levels of the system.

In yet another embodiment, the locations at which dosages are calculated lie on a grid having a spacing less than $\beta_b$.

For a better understanding of the present invention reference may be had to the accompanying drawings which are incorporated herein by reference and in which:

FIG. 1 is a block diagram of an electron beam lithography system;

FIG. 2A-2C illustrate the proximity effect in a resist-coated workpiece;

FIG. 3 illustrates a sample pattern and a plurality of locations at which required electron dosage is calculated;

FIG. 4 is a flow chart illustrating the method of the present invention;

FIG. 5 illustrates a rectangular pattern for which P*S is calculated; and

FIG. 6 illustrates a sample pattern for which the required electron dosage was determined in accordance with the present invention.

A highly simplified block diagram of an electron beam lithography system is shown in FIG. 1. An electron optical column 10 includes an electron source, beam shaping optics, projection and demagnification optics and means for deflecting the beam. The output of the column 10 is a finely focused electron beam 12 which is applied to the surface of a workpiece 14. The workpiece 14 is typically a resist-coated semiconductor wafer or mask plate and is mounted on a stage 16. The stage 16 is movable in the x, y directions perpendicular to the electron beam 12. The combination of movement by the stage 16, and deflection of the electron beam 12 permits the entire surface of the workpiece 14 to be exposed by the electron beam 12. It will be understood that the region traversed by the electron beam 12, between the electron source and the workpiece 14, is maintained at high vacuum by suitable vacuum pumping means (not shown). The electron optical column 10 and the stage 16 are controlled by a suitable control system, typically including one or more computers and other control circuitry. In the system of FIG. 1, a computer 20 provides signals through a column control subsystem 22 to the column 10 to control the electron source, the centering coils, the lenses and other elements of the electron beam column. Similarly, the computer 20 operates through a stage control subsystem 24 to control the x, y movement of the stage 16 in a highly accurate manner. A laser interferometer senses the position of the stage 16. The data representing the pattern to be exposed on the workpiece is stored on a pattern storage disc 30. For typical LSI or VLSI semiconductor devices, the quantity of data necessary to represent a complete pattern is on the order of several megabytes. The data is removed by the computer 20 from the pattern storage disc 30 in blocks and transferred to a high speed pattern memory 32. A pattern generator subsystem 34 operates on pattern data received from the pattern memory 32 and generates signals which operate through beam shaping and deflection electronics 36 to control the shape, size and position of the electron beam 12 which is applied to the workpiece 14.

In operation, the electron beam is directed to the areas of the workpiece 14 where pattern features are desired and is turned on to expose the electron resist. The beam is shaped, in accordance with the pattern data, to have a cross-section corresponding with the desired pattern. In one type of system, rectangular pattern features and subfeatures are flash exposed. In a preferred system, the electron beam 12 is shaped to a narrow line of variable length and is scanned over the area of the pattern feature. While the electron beam has a scan field limited to about one millimeter, the x, y movement of the stage 16 permits exposure of the entire workpiece 14, which may be up to several inches in dimension.

In electron beam lithography systems of the type shown in FIG. 1, it is desired to process extremely complex and extremely miniaturized devices which can have minimum feature sizes in the range of one micrometer or less. The proximity effect causes serious problems when attempting to delineate such features with an electron beam. Referring to FIG. 2A, there is shown an enlarged, partial cross-sectional view of the workpiece 14 illustrating the proximity effect. The workpiece 14 includes a substrate 40 coated with a layer of resist 42 which is typically a polymer in the range of a micron or less in thickness. Electron sensitive resists are generally known in the art. When the electron beam 12 is incident upon a point A on the surface of the resist 42, the beam 12 is forward scattered, as indicated at 44, as it passes through the resist layer 42. When the beam 12 strikes the substrate 40, it is backscattered, as indicated at 46, into the resist 42. Thus, the incident electron beam 12 striking at point A causes exposure of a region surrounding point A. The exposure distribution for an incident delta function electron beam is represented graphically in FIG. 2B. The distribution includes two Gaussian functions, a curve 50 representing forward scattering and having a width $\beta_f$ and a curve 52 representing backscattering and having a width $\beta_b$. For typical resists and substrates, the width of the backscattering function $\beta_b$ is substantially greater than the width of the forward scattering function $\beta_f$. The total exposure caused by the beam is the sum of these two scattering functions indicated by a curve 54.

In calculating total exposure at a prescribed point, account must be taken not only of exposure resulting from nearby patterns but also exposure resulting from nearby portions of the same pattern. This effect is illustrated in FIG. 2C where top views of arbitrarily shaped pattern features 60 and 62 are illustrated. An electron beam incident upon the point P in pattern feature 60 has an area of effective influence indicated by the circle in FIG. 2C. The radius of the circle depends on the width of the distribution function shown in FIG. 2B. Conversely, the total exposure at the point P is a summation of contributions from the features 60, 62 within the circle. Depending on the size and closeness of the surrounding features, total exposure at the point P will vary. This is the fundamental problem caused by the proximity effect. Points P within patterns can be underexposed if there is insufficient exposure contribution from surrounding pattern features. Likewise, points P in nonpattern areas can be above some threshold limit if there is a high density of surrounding pattern areas.

In accordance with the present invention, the proximity effect is corrected so that the exposure of all the features in the pattern is within prescribed limits. In performing the correction, the pattern to be written on the workpiece is overlaid with an imaginary x, y grid. The spacing between adjacent grid lines and is less than the characteristic width $\beta_b$ of the backward scattering function. The incident electron dosage I(x, y) required to produce uniform exposure within the pattern areas is calculated by a method to be described hereinafter. The values of I are analyzed to determine appropriate partitioning of the pattern features into subfeatures which will receive uniform electron dosage. The pattern is then exposed by the electron beam lithography system one subpattern at a time, and the electron beam dosage is adjusted in accordance with the values of I. For the case of a line beam of variable length which scans a feature, the scan speed is varied in order to adjust the electron dosage. For the case of the flash exposure-type system, the dwell time, or on-time, of the beam at each subfeature is varied.

The derivation and calculation of the required incident electron dosage I(x, y) is given below. While the variables are expressed as a function of x for simplicity, it will be understood that each variable is a function of x and y in the plane of the workpiece. The exposure f(x) due to a delta function electron beam incident upon the resist layer at a point is given by

$$f(x) = A \cdot \delta(x) + B \cdot S(x) \qquad (1)$$

where A and B are constants which are functions of the resist material, the substrate material and the electron energy. A is the fraction of deposited energy contained in the narrow forward scattered portion and B is the fraction contained in the broad backward scattered portion. The sum of A and B is one. S(x) is the distribution function or spreading function due to backscattering of electrons.

$$S(x) = \frac{1}{\beta_b \sqrt{\pi}} \exp\left[-x^2/\beta_b^2\right] \qquad (2)$$

The forward scattering of incident electrons is approximated by the delta function $\delta(x)$, since the forward scattering distribution is narrow in comparison with backscattering and smaller than the feature sizes of interest. The resultant exposure R(x) due to an electron dosage I(x) is given by

$$R(x) = A \cdot I(x) + B \int_{-\infty}^{+\infty} S(x-x')\ I(x')\ dx' \qquad (3)$$

The resultant exposure R(x) can be thought of as an exposure due to direct impingement of electrons plus a summation of exposures due to scattering of nearby incident electrons in accordance with the spreading function S(x). Now define a function P(x) representing the desired pattern on the workpiece

$$P(x) = \begin{cases} 1 & \text{inside pattern areas} \\ 0 & \text{outside pattern areas} \end{cases} \qquad (4)$$

Clearly, $I(x) = P(x) \cdot I(x)$ since the electron beam is applied only inside pattern areas. Multiplying both sides of equation (3) by P(x) and applying the above identity gives

$$P(x) \cdot R(x) = A \cdot P(x) \cdot I(x) + B \cdot P(x) \int_{-\infty}^{+\infty} S(x-x') \cdot P(x') \cdot I(x')dx' \qquad (5)$$

It is desired to make R(x) uniform inside the pattern areas. Thus, setting R(x) = 1

$$P(x) = A \cdot I(x) + B \int_{-\infty}^{+\infty} P(x) \cdot S(x-x') \cdot P(x') \cdot I(x')dx' \qquad (6)$$

It is necessary to obtain a solution of equation (6) for I(x), the electron dosage which produces uniform exposure. It is useful to consider limiting conditions. In the case of very sparse pattern features, the integral term of equation (6) approaches zero. In the case of very dense pattern features, the integral term of equation (6) approaches one. Moreover, the integral term tends to follow the variation of I(x), but is much more slowly varying.

Thus, the following approximation can be attempted.

$$P(x)=A\cdot I(x)+B\cdot P(x)\cdot I(x) \int_{-\infty}^{+\infty} S(x-x')\cdot P(x')dx' \qquad (7)$$

The integral in equation (7) is known as a convolution integral and is commonly denoted by $P(x)*S(x)$ or simply $P*S$. Solving for $I(x)$ gives

$$I(x) = P(x)\left[\frac{1}{A + B\cdot(P*S)}\right] \qquad (8)$$

The approximate solution give by equation (8) is the value of electron dosage at any point on the surface of the workpiece required to produce uniform exposure. The error depends on the relative values of A and B. However, the solution is good to about 5 percent for normally encountered values of A and B. With an additional correction factor, the solution can be made accurate to within about three percent.

$$I(x) = P(x)\left[\frac{1}{A + B\cdot(P*S)} + k_1\,[\nabla\cdot\,(P*S)]^2\right] \qquad (9)$$

where $k_1 = \frac{B^2\beta_b{}^2}{2}$

and $\nabla\cdot\,(P*S)$ represents the gradient of $P*S$.

The method of the present invention is illustrated in FIG. 4. The pattern $P(x, y)$ for a particular layer is established in accordance with the design of the integrated circuit semiconductor device being fabricated. A complete device typically requires several separate patterning steps for fabricating device electrodes, interconnections, etc., in a layer-by-layer fashion. A portion of a sample pattern comprising features 70, 71, 72 is illustrated in FIG. 3. It will be understood that a complex semiconductor device typically includes hundreds or thousands of these pattern features. The values of $\beta_b$, A and B are determined for the particular resist, substrate and electron beam energy.

In calculating the electron dosage to be applied to each of the features 70, 71, 72, the pattern is overlaid with an imaginary x, y grid. A portion of the grid is indicated by x's in FIG. 3. Typically, the spacing of the grid elements is somewhat less than $\beta_b$, the characteristic width of the backscattering function and is dependent on the method of interpolation which will be used to find values between grid points. For example, if linear interpolation is used, a grid spacing of $.4\beta_b$ is appropriate. If quadratic interpolation is used, a value of $.9\beta_b$ is appropriate. At each of the grid points, the value of the expression within brackets in equation (8) or equation (9) is calculated. The values are calculated at points outside the pattern as well as inside the pattern for reasons described below. This provides a contour of required electron dosage levels necessary to produce uniform exposure in the pattern features 70, 71, 72. Since the grid points have been closely spaced in relation to the spreading function, the values will be slowly varying.

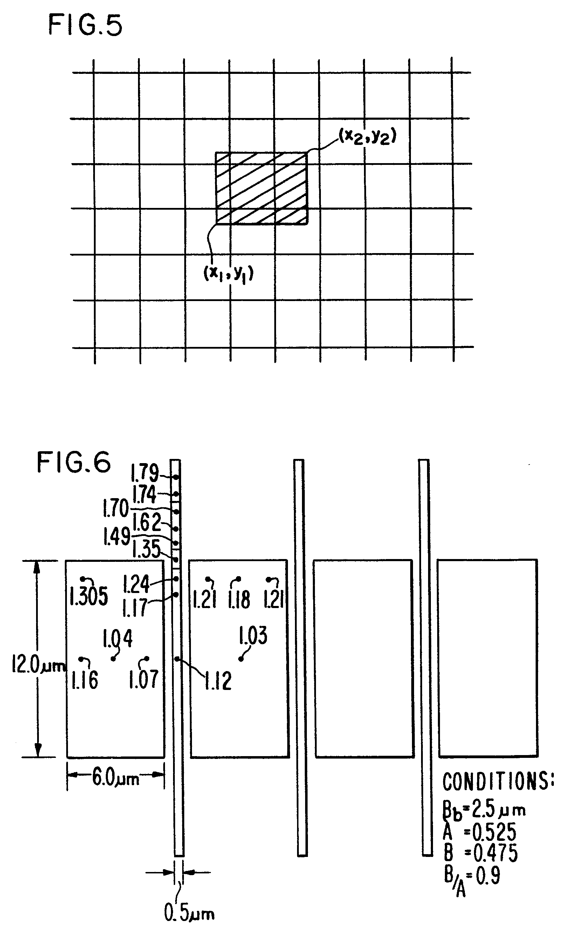

The calculation of P*S at a regular array of sample points is easy and straightforward for rectangular features. Consider the rectangular feature shown in FIG. 5 and defined by the points $(x_1, y_1)$ and $(x_2, y_2)$. The function $B_S(x)$ can be defined as

$$B_S(x) = \frac{1}{2}\left[1 - \mathrm{ERF}\,\frac{x}{\beta}\right] \tag{10}$$

where ERF(x) is the error function defined by

$$\mathrm{ERF}(x) = \frac{2}{\sqrt{\pi}} \int_0^x e^{-u^2}\, du \tag{11}$$

The function $B_S(x)$ represents the result of convolving a Gaussian backscattering distribution with a step function. One edge of the rectangular feature is a positive step function, while the other edge is a negative step function. The value of $(P{*}S)$ at any grid point (x, y) is simply

$$(P{*}S)\Big|_{x,y} = \left[B_S(x_1-x)-B_S(x_2-x)\right] \cdot \left[B_S(y_1-y)-B_S(y_2-y)\right] \tag{12}$$

Since the dependences on x and y are in separate product terms, in the case of an array of points in a rectangular grid, the calculation can be performed by calculating the factors for the rows and columns and then calculating the products at the same points. The above calculation for rectangular features is applicable to 95% or more of the features in a typical semiconductor device pattern, since most complex patterns can be broken down into a series of rectangles.

In theory, the calculated values of required electron dosage can be used directly to control the dosage applied by the electron beam writing system.

However, since the dosage values vary continuously over every pattern feature, the quantity of data for a complete semiconductor chip is large. Moreover, present machines do not have the ability to vary the dose in a continuous fashion but are limited to changing the dose only between features or subfeatures. In practical systems, one must expose each feature at its appropriate average value or must partition the feature into subfeatures. For example, the electron beam column may be capable of applying normalized dosage values of 1.0, 1.1, 1.2, 1.3, 1.4, 1.5, etc. These values can be obtained by varying dwell time in discrete steps in a step-and-flash system or by varying sweep speed in discrete steps in a continuously scanned system. Also, the electron beam current can be varied in steps if desired.

It will be understood that the calculated values of required electron dosage will vary over the area of a single pattern feature due to the proximity effect. For example, where the features 70, 71, 72 in FIG. 3 are closely spaced and in the interior portion of large features, less electron dosage will be required. In order to accommodate this variation to the discrete dosage levels of the electron beam system, it is necessary in most cases to partition, or subdivide, the pattern features into subfeatures. Each subfeature is then assigned to one of the dosage levels of the electron beam system in accordance with the calculated value of required electron dosage. Suppose, for example, that the required exposure accuracy is ± 5% and that the electron beam system uses the normalized dosage levels listed above. For a feature having calculated required electron dosage in the range of 1.05 to 1.15, the entire feature can be exposed at 1.1, and no partitioning is necessary. For a feature having calculated required electron dosage in the range of 1.05 to 1.35, partitioning into at least three subfeatures is necessary. The three subfeatures are exposed at 1.1, 1.2 and 1.3. As the required dosage accuracy increases, more partitioning of the pattern features will be necessary. It can be seen that the partitioning information is obtained directly from the calculated values of required electron dosage, since it is known where on the feature the required dosage is high and where the required dosage is low. The provision of partitioning information is a major advantage of the present invention over prior art techniques.

The required electron dosage at the edges of pattern features is critical, since bridging between adjacent features can be a problem. The grid points at which calculations are made do not necessarily coincide with the edges of all pattern features. The spacing of the grid points is a matter of choice, depending on the accuracy desired, the kind of interpolation to be used, the parameters of the resist and the amount of exposure variation that can be tolerated. However, as the number of grid points increases, the computation time by a computer increases. It is therefore desirable to interpolate between grid points in critical areas, such as the edge of a feature, rather than to increase the number of grid points. To obtain dosage levels at the edge of a feature, an interpolation is performed between grid points outside and inside the feature edge. Furthermore, an increase in the number of dosage levels which can be applied by the electron beam system will improve exposure accuracy but will also increase processing time, since more partitioning is necessary. The method in accordance with the present invention has the flexibility to vary these parameters in accordance with the requirements of a particular process and device. The computation time is proportional to the number of pattern features, the grid size and the required accuracy. By contrast, the prior art methods have involved the solution of simultaneous equations wherein the computation time increases as the cube of the number of pattern features increases.

The results of a calculation for a sample pattern using the method of the present invention are illustrated in FIG. 6. The values of the constants were as follows:

$$\beta_b = 2.5 \text{ micrometers, } A = 0.525 \text{ and } B = 0.475$$

The wide variation in required electron dosage between the interior of large features (1.03) and small, isolated features (1.79) is apparent.

In all of the preceding discussion, it has been assumed that the objective was to determine the proper incident dose required to make the deposited energy in exposed features uniform. However, depending on the characteristics of the resist and the development process, it may in fact be better to reduce the total deposited energy somewhat as the contribution of the backscattered portion increases. In particular, if the expression given by equation (8) or (9) is used, then the energy deposited by the forward scattering is given by

$$E_F(x) = A \cdot I(x) \tag{13}$$

and the deposited energy from backward scattering is approximately

$$E_B(x) = 1 - A \cdot I(x) \tag{14}$$

since the value of I(x) from equation (8) or (9) provides for total deposited energy of 1. If from studies of the development process, it is determined that the total deposited energy should be decreased as $E_B(x)$ increases, then the left-hand side of equation (7) should be replaced by

$$P(x)\ [1 - k\ (1 - A \cdot I(x))] \tag{15}$$

where k is a constant determined from studies of the resist development process. Then the solution given by equation (8) would become

$$I(x) = P(x) \left[ \frac{(1-k)}{A(1-k) + B \cdot (P_* S)} \right] \tag{16}$$

and equation (9) would become

$$I(x)=P(x) \left\{ \frac{(1-k)}{A(1-k)+B \cdot (P_* S)} + \frac{B^2 \beta_b^2}{2} [\nabla \cdot (P_* S)]^2 \right\} \tag{17}$$

While there has been shown and described what is at present considered the preferred embodiments of the invention, it will be obvious to those skilled in the art that various changes and modifications may be made therein without departing from the scope of the invention as defined by the appended claims.

Claims

1. A method for electron beam lithography writing of a microminiature pattern P(x, y) on a resist-coated workpiece comprising the steps of:

calculating, at a plurality of locations on said workpiece, the electron dosage required to produce uniform exposure of said pattern P(x, y) in accordance with the expression

$$\frac{1}{A + B \cdot P(x, y) * S(x, y)}$$

where S(x, y) represents the backscattered exposure distribution produced by an incident electron beam, P(x, y)*S(x, y) represents the convolution of P and S, and A and B are constants dependent on the parameters of said resist and said workpiece and on the energy of the incident electrons; and

writing said pattern P(x, y) on said workpiece with said electron beam from said electron beam lithography system while varying the applied electron dosage in accordance with the calculated values of required electron dosage.

2. The method as defined in claim 1 wherein the exposure distribution S(x, y) is given by

$$S(x, y) = \frac{1}{\beta_b^2 \pi} \exp\,[-x^2 + y^2)/\beta_b^2]$$

where $\beta_b$ is the characteristic width of the exposure distribution.

3. The method as defined in claim 2 wherein the step of calculating the required electron dosage includes the step of adding to the calculated values a correction factor $k_1[\nabla \cdot (P*S)]^2$ where $k_1 = \frac{B^2 \beta b^2}{2}$ and $\nabla \cdot (P*S)$ represents the gradient of $P(x, y)*S(x, y)$.

4. The method as defined in claim 3 wherein said locations lie on a grid having a spacing between adjacent locations less than $\beta b$.

5. The method as defined in claim 3 wherein said step of writing said pattern $P(x, y)$ is performed with a prescribed number of discrete electron dosage levels and further including the step of partitioning the features of said pattern $P(x, y)$ into subfeatures in accordance with said calculated values of required electron dosage and assigning each subfeature to the one of said discrete electron dosage levels which is closest to the calculated range of values for that subfeature.

6. The method as defined in claim 5 wherein said electron beam lithography system employs variable length line scanning of pattern subfeatures and wherein said discrete electron dosage levels are obtained by providing said prescribed number of scan speeds.

7. The method as defined in claim 5 wherein said electron beam lithography system employs step-and-flash exposure of pattern subfeatures and wherein said discrete electron dosage levels are obtained by providing said prescribed number of discrete flash durations.

8. The method as defined in claim 5 wherein said discrete dosage levels are obtained by providing said prescribed number of electron beam current levels.

9. The method as defined in claim 5 wherein the required electron dosage for points between said locations is determined by interpolation between adjacent locations.

10. The method as defined in claim 1 wherein the step of calculating the required electron dosage includes the step of reducing said required electron dosage by an amount in proportion to the backward scattered energy.

11. A method for electron beam lithography writing of a microminiature pattern P(x, y) on a resist-coated workpiece which approximately corrects for the proximity effect, said method comprising the steps of:

calculating the electron dosage required to produce uniform exposure of said pattern at a plurality of locations on said workiece, said locations having a spacing less than $\beta_b$, the characteristic width of the backscattering distribution S(x, y) produced by an electron beam incident upon said resist at a point in accordance with the expression

$$\frac{1}{A+B\cdot P(x, y)*S(x, y)} + \frac{B^2\beta_b^2}{2}[\nabla\cdot(P(x, y)*S(x, y))]^2$$

where P(x, y)*S(x, y) represents the convolution of P and S, $\nabla\cdot$(P(x, y)*S(x, y)) represents the gradient of P(x, y)*S(x, y), and A and B are constants dependent on the parameters of said resist and said workpiece and on the energy of the incident electrons;

partitioning the features of said pattern P(x, y) into subfeatures in accordance with the calculated values of required electron dosage;

assigning each of said subfeatures to one of a prescribed number of discrete electron dosage levels; and

exposing each of said subfeatures of said pattern P(x, y) with said electron beam from said electron beam lithography system at said assigned discrete electron dosage level.

12. The method as defined in claim 11 wherein said step of partitioning the features of said pattern P(x, y) includes the step of determining the range of calculated values of required electron dosage within each pattern feature and dividing said feature in accordance with said range of values.

13. The method as defined in claim 12 wherein said step of determining the range of calculated values within each pattern feature includes the step of determining the required electron dosage at the edge of a pattern feature by interpolation between calculated values at adjacent locations.

14. A method for electron beam lithography writing of a microminiature pattern P(x, y) on a resist-coated workpiece which approximately corrects for the proximity effect, said method comprising the steps of:

calculating the electron dosage required to produce uniform exposure of said pattern at a plurality of locations on said workiece, said locations having a spacing less than $\beta_b$, the characteristic width of the backscattering distribution S(x, y) produced by an electron beam incident upon said resist at a point in accordance with the expression

$$\frac{1-k}{A(1-k) + B \cdot P(x, y) * S(x, y)}$$

where P(x, y)*S(x, y) represents the convolution of P and S, A and B are constants dependent on the parameters of said resist and said workpiece and on the energy of the incident electrons, and k is a constant determined from the resist development process;

partitioning the features of said pattern P(x, y) into subfeatures in accordance with the calculated values of required electron dosage;

assigning each of said subfeatures to one of a prescribed number of discrete electron dosage levels; and

exposing each of said subfeatures of said pattern P(x, y) with said electron beam from said electron beam lithography system at said assigned discrete electron dosage level.

15. The method as defined in claim 14 wherein the step of calculating the required electron dosage includes the step of adding to the calculated values a correction factor $k_1[\nabla \cdot (P*S)]^2$ where $k_1 = \frac{B^2 \beta_b^2}{2}$ and $\nabla \cdot (P*S)$ represents the gradient of P(x, y)*S(x, y).

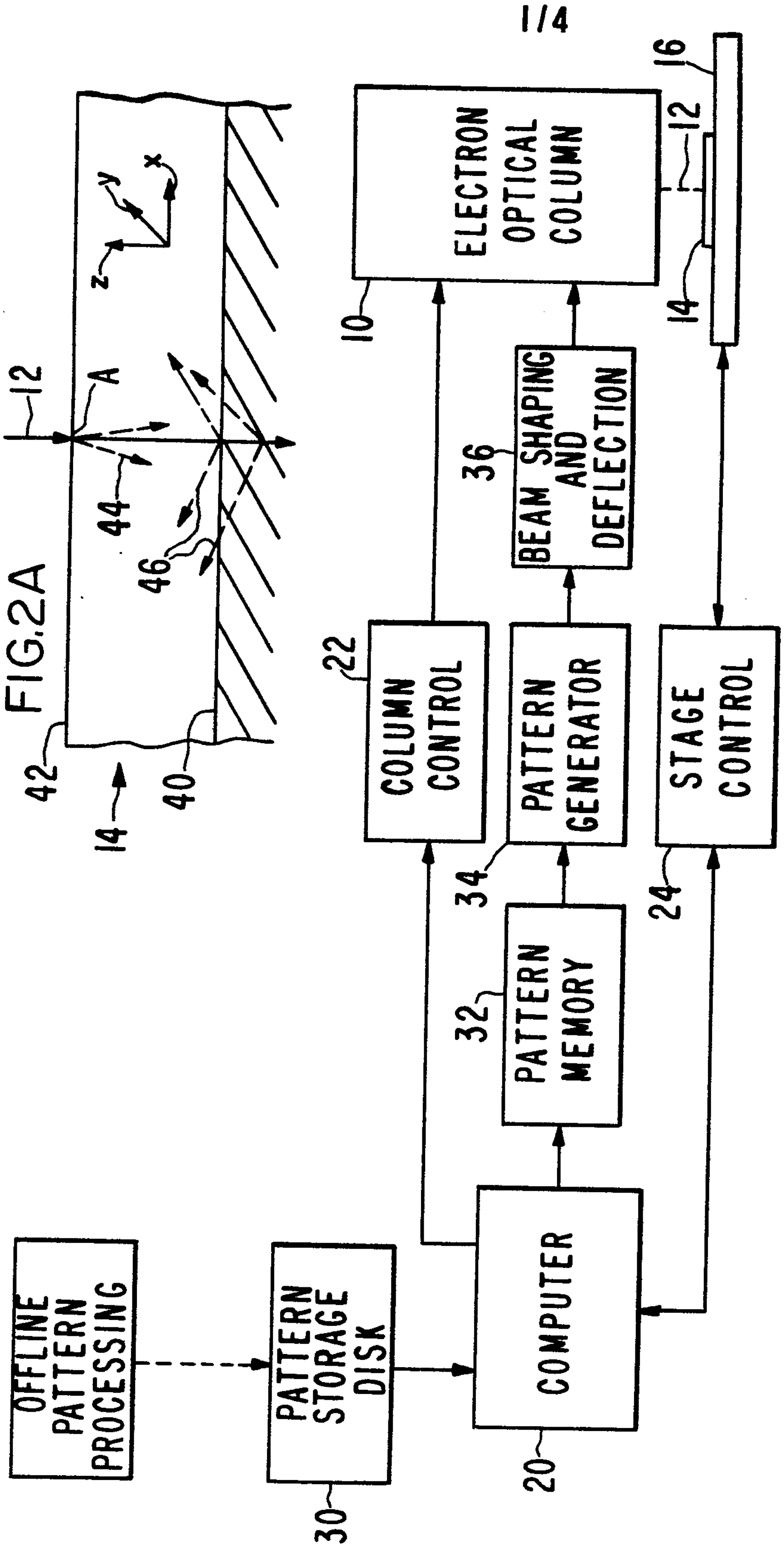
12
A
z
y
x
44
46
42
14
40
ELECTRON OPTICAL COLUMN
10
16
12
14
BEAM SHAPING AND DEFLECTION
36
COLUMN CONTROL
22
PATTERN GENERATOR
34
STAGE CONTROL
24
PATTERN MEMORY
32
OFFLINE PATTERN PROCESSING
PATTERN STORAGE DISK
30
COMPUTER
20

FIG.2A

FIG.1

FIG.2B

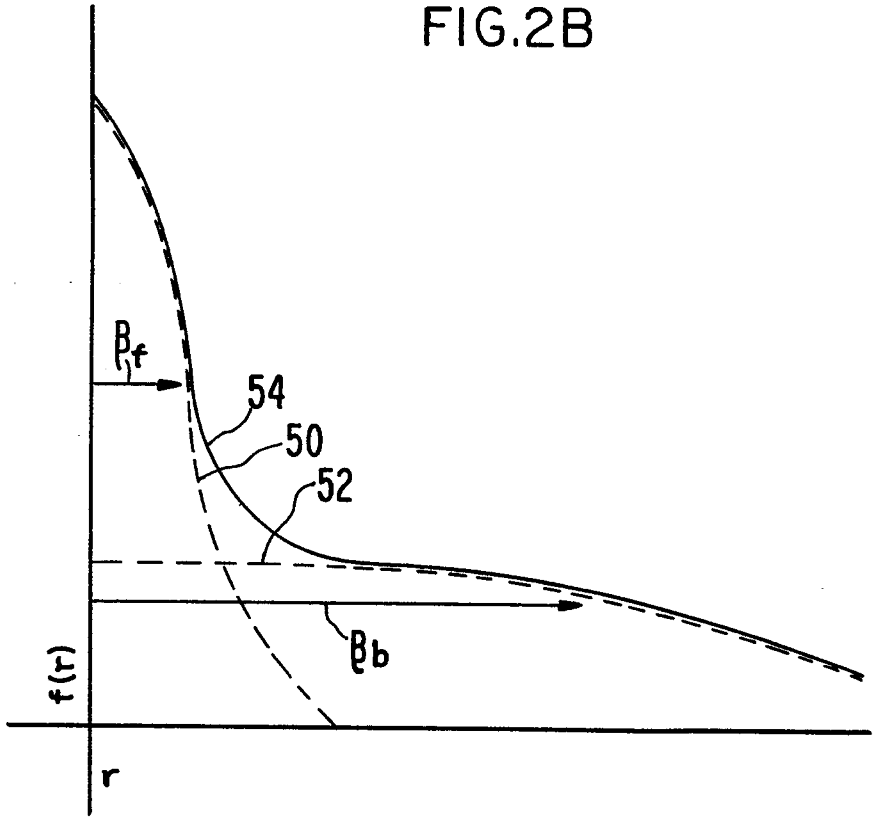


FIG.2C

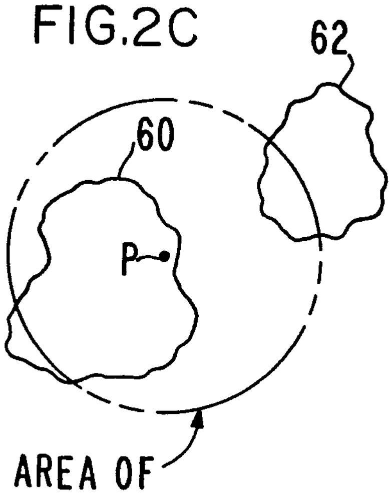


FIG.3

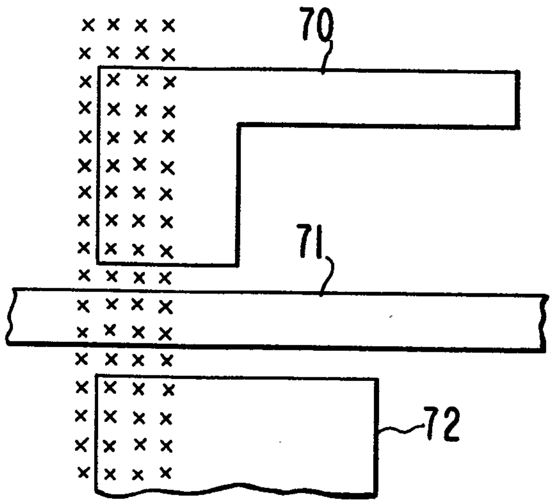

FIG.4

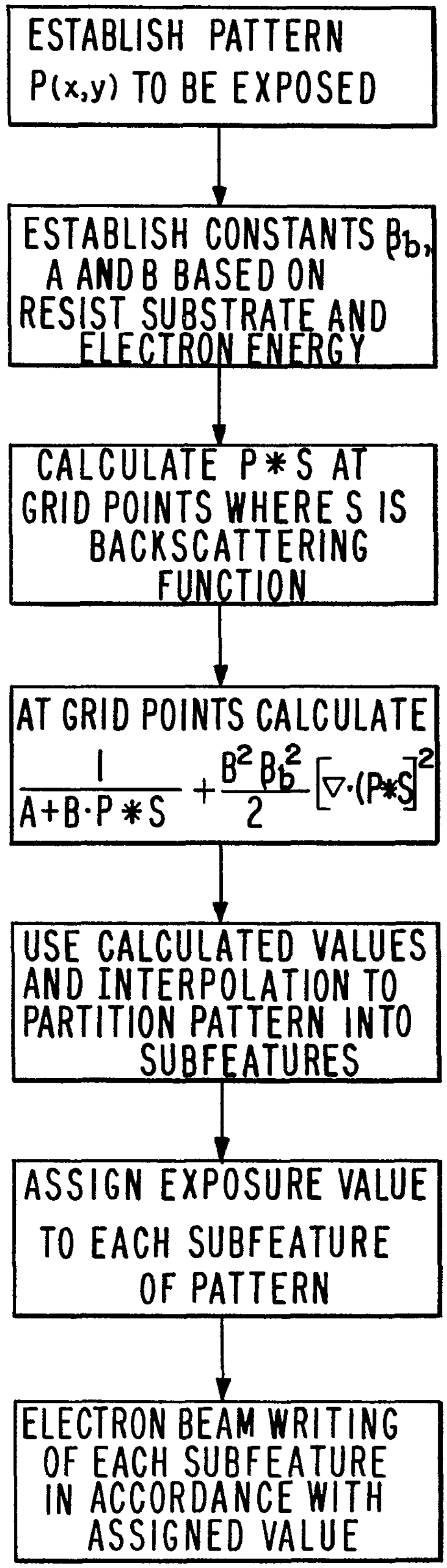
ESTABLISH PATTERN P(x,y) TO BE EXPOSED
ESTABLISH CONSTANTS $\beta_b$, A AND B BASED ON RESIST SUBSTRATE AND ELECTRON ENERGY
CALCULATE P∗S AT GRID POINTS WHERE S IS BACKSCATTERING FUNCTION
AT GRID POINTS CALCULATE
$\frac{1}{A+B\cdot P*S}+\frac{B^2\beta_b^2}{2}[\nabla\cdot(P*S)]^2$
USE CALCULATED VALUES AND INTERPOLATION TO PARTITION PATTERN INTO SUBFEATURES
ASSIGN EXPOSURE VALUE TO EACH SUBFEATURE OF PATTERN
ELECTRON BEAM WRITING OF EACH SUBFEATURE IN ACCORDANCE WITH ASSIGNED VALUE

0166549

4/4

FIG.5

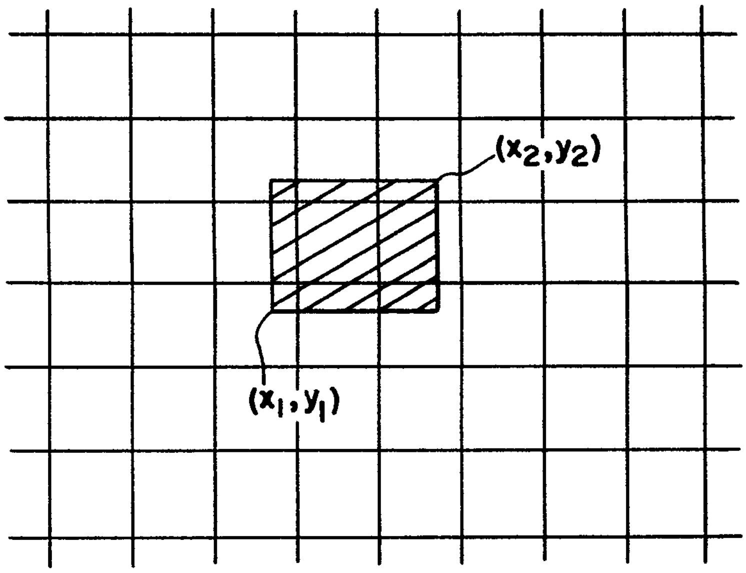


FIG.6